# EUROPEAN PATENT APPLICATION

(11) **EP 4 207 284 A1**
(43) Date of publication of application: **05.07.2023**
(21) Application number: 21218447.7
(22) Date of filing: 31.12.2021
(51) Int. Cl.: H01L 27/02, H01L 29/861

(54) **SEMICONDUCTOR DEVICE AND BIDIRECTIONAL ESD PROTECTION DEVICE**

(71) Applicant: Nexperia B.V., 6534 AB Nijmegen (NL)
(72) Inventor: Kumar, Vasantha, 22529 Hamburg (DE); Ritter, Hans-Martin, 22529 Hamburg (DE)
(74) Representative: Pjanovic, Ilija

(57) **Abstract**

Aspects of the present disclosure relate to a semiconductor device. More in particular, the present disclosure relates to a semiconductor device that is particularly useful for ESD protection purposes. The semiconductor device according to the present disclosure comprises a semiconductor die; a plurality of diode unit cells integrated on the semiconductor die and being electrically connected between the first and second terminal, each unit cell comprising a first region of a first charge type in the semiconductor die and a second region of a second charge type in the semiconductor die; an isolation structure arranged in the semiconductor die, the isolation structure being configured to electrically isolate the plurality of unit cells from one another in the semiconductor die; and a plurality of contacts comprising first contacts that are electrically connected to the first terminal and second contacts that are electrically connected to the second terminal, wherein each contact among the first and second contacts is electrically connected to the first region of a respective unit cell among the plurality of unit cells and to the second region of another unit cell among the plurality of unit cells.

## Description

Aspects of the present disclosure relate to a semiconductor device. More in particular, the present disclosure relates to a semiconductor device that is particularly useful for ESD protection purposes.

Electronic devices and circuits may be subject to electrostatic discharge (ESD) events, for example due to close contact between said device (or circuit) with a differently charged object, or due to a breakdown of a dielectric between said device (or circuit) and said object, resulting in a sudden flow of electricity. Excessive currents due to a sudden discharge from an ESD event can cause significant and/or permanent damage to sensitive electronic devices.

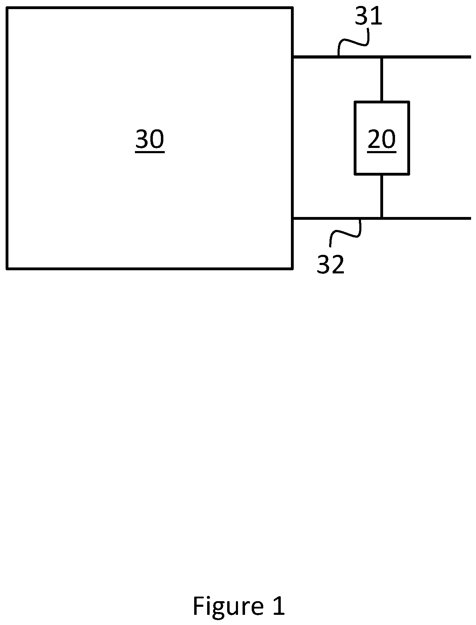

ESD protection devices can be used to prevent such damage to electronic devices or circuits. For example, a dedicated ESD protection device can be electrically connected in parallel to the electronic device to shunt the ESD current. An exemplary configuration is shown in Figure 1, in which an ESD protection device 20 is connected in between, for example, a signal line 31 (e.g., a data line) and a rail line 32 (or another signal line) of an electronic circuit 30, such as an integrated circuit (IC). Alternatively, ESD protection device 20 can be integrated with electronic circuit 30 into a single IC. Here, it is noted that the ESD protection device 20 may be connected between any two terminals of electronic circuit 20.

Generally, the ESD protection device has a relatively high current handling capability, and prevents or limits an ESD current due to an ESD event from flowing through the sensitive electronic device(s) by allowing a substantial portion of said current to flow through the ESD protection device instead. At the same time, the ESD protection device should limit the voltages within the sensitive electronic device(s) or circuit(s) to sufficiently low levels to prevent damage to connected electronic device(s) or circuit(s) to be protected.

For many applications, such as high data rate communication, ESD protection devices are preferably bidirectional and have a low capacitive load on the circuit to be protected, a high robustness and a relatively low trigger and holding voltage. Antiparallel diodes or antiparallel diode stacks are a suitable option to achieve a high performance in accordance with these parameters.

Typically, a relatively large diode width is needed to accommodate the ESD current during an ESD event. This is usually realized by arranging a plurality of diode unit cells in parallel. The plurality of unit cells are for example integrated on a same semiconductor die and connected in parallel via a metal layer or metal layer stack of the semiconductor die. The known ESD protection devices are typically made bidirectional by providing a first and second plurality of unit cells as described above, arranged separately on a same semiconductor die or on different semiconductor dies, and connecting them in an anti-parallel configuration.

A major challenge in the realization of ESD protection devices as described above is related to minimizing the capacitive loading by said ESD protection device on a circuit to be protected. In particular, during normal operation (i.e., in absence of an ESD event), the ESD protection device should load the circuit to be protected as little as possible, lest the circuit performance is degraded. For example, in high-speed communication applications, a capacitive loading due to the presence of an ESD protection device is detrimental to a maximum communication speed of the circuit to be protected.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a semiconductor device is provided. The semiconductor device has a first terminal and a second terminal, and comprises a semiconductor die, and a plurality of diode unit cells integrated on the semiconductor die and being electrically connected between the first and second terminal, each unit cell comprising a first region of a first charge type in the semiconductor die and a second region of a second charge type in the semiconductor die. Furthermore, the semiconductor device comprises an isolation structure arranged in the semiconductor die, the isolation structure being configured to electrically isolate the plurality of unit cells from one another in the semiconductor die, and a plurality of contacts comprising first contacts that are electrically connected to the first terminal and second contacts that are electrically connected to the second terminal. Each contact among the first and second contacts is electrically connected to the first region of a respective unit cell among the plurality of unit cells and to the second region of another unit cell among the plurality of unit cells.

In the semiconductor device according to the present disclosure, the first contacts and the second contacts can carry a current in both directions due to being connected to both a first region and a second region, the direction of the current being dependent on a polarity of a voltage across the first and second terminal and on the selected charge type for the first and second region. As such, the total amount of interconnect material (e.g., metallization) for the contacts can be significantly reduced, leading to a lower capacitive loading on a circuit to be protected, when the semiconductor device is electrically connected thereto.

The plurality of unit cells may be arranged in a plurality of groups, each group having two or more unit cells that are connected in series via one or more intermediate contacts. Each intermediate contact may be electrically connected to the first region of a respective unit cell among unit cells in said group and to the second region of another unit cell among unit cells in said group. By connecting multiple groups of unit cells among the plurality of unit cells in series, a stacked diode configuration can be achieved in a manner that still enables the first and second contacts to carry a current in both directions between the first and second terminal.

A first portion of intermediate contacts may be arranged in an interleaved manner with first contacts, and a second portion of intermediate contacts may be arranged in an interleaved manner with second contacts. Furthermore, intermediate contacts among the first portion of intermediate contacts may each be electrically connected to at least one intermediate contact among the second portion of intermediate contacts. Alternatively, the first contacts and the second contacts may be alternatingly arranged, and the intermediate contacts may be arranged in between said first contacts and second contacts. In doing so, an area-efficient and low-capacitance stacked diode configuration can be realized.

Unit cells that are electrically connected to a same first contact, a same second contact and/or, if applicable, a same intermediate contact may be adjacently arranged, in which case the total amount of interconnect material for the contacts can be minimized.

A first portion of the plurality of unit cells or, in so far as applicable, the plurality of groups may be arranged in parallel to one another between the first and second terminal, and a second portion of the plurality of unit cells or, in so far as applicable, the plurality of groups may be arranged in anti-parallel to the first portion between the first and second terminal.

The first contacts may be electrically connected to one another via a first interconnecting portion. The first interconnecting portion may form or may be electrically connected to the first terminal. Additionally or alternatively, the second contacts may be electrically connected to one another via a second interconnecting portion. The second interconnecting portion may form or may be electrically connected to the second terminal.

The first contacts, the second contacts and/or, if applicable, the intermediate contacts may be finger-shaped. For example, the unit cells may be arranged in a multi-finger structure.

The semiconductor die may comprise a semiconductor substrate and an epitaxial layer, wherein the plurality of unit cells are formed in the epitaxial layer.

The isolation structure may comprise a plurality of vertical isolation structures and a plurality of lateral isolation structures. The vertical isolation structures may each be arranged in between adjacent unit cells among the plurality of unit cells, and the plurality of lateral isolation structures may each be arranged below a respective unit cell among the plurality of unit cells with respect to a top surface of the semiconductor die. The vertical isolation structures may extend from said top surface at least to the lateral isolation structures.

The vertical isolation structures may each extend from the top surface in a first direction that is substantially perpendicular to said top surface, and the lateral isolation structures may each extend in a second direction that is substantially parallel to said top surface.

The lateral isolation structures may be formed by respective buried insulating layers, such as a buried oxide layer. In some embodiments, the buried insulating layers may together form respective portions of a contiguous buried insulating layer.

The plurality of lateral isolation structures may be formed by respective PN junctions extending between the vertical isolation structures arranged adjacent to a corresponding unit cell.

In some embodiments, the epitaxial layer may be of a different charge type with respect to the semiconductor substrate, and the PN junctions may be formed by junctions between the epitaxial layer and the semiconductor substrate. In alternative embodiments, a well region in the epitaxial layer in which the plurality of unit cells may be arranged may be of a different charge type with respect to a remainder of the epitaxial layer and/or the semiconductor substrate, and the PN junctions may be formed by respective junctions between the epitaxial layer and the semiconductor substrate, and/or by respective junctions between the well region and the epitaxial layer.

The PN junctions may each be formed by a respective first buried region of the first or second charge type in the semiconductor die and a respective second buried region of the second or first charge type, respectively, in the semiconductor die. Each of the second buried regions may be spaced apart from the epitaxial layer by a corresponding first buried region.

The vertical isolation structures may each comprise a trench. The trench may have an insulating material arranged therein, such as an oxide material.

One of the first and second region of each unit cell among the plurality of unit cells may extend from a top surface of the semiconductor die to the buried insulating layer. The epitaxial layer or a well region in the epitaxial layer in which the plurality of unit cells may be arranged may be of the second charge type. In that case, the vertical isolation structures may each be formed by a respective PN junction between said one of the first and second region of a respective unit cell and the epitaxial layer or the well region.

Alternatively, both the first region and the second region of each unit cell among the plurality of unit cells extends from a top surface of the semiconductor die to the buried insulating layer. The vertical isolation structures may then be formed by respective PN junctions between one of the first and second region of a respective unit cell and the epitaxial layer or, if applicable, a well region in the epitaxial layer in which the plurality of unit cells are arranged, or between the first region of a respective unit cell and the second region of a unit cell arranged directly adjacent to said first region.

The plurality of contacts and, if applicable, the first and second interconnecting portions may be arranged in a metal layer, or in one or more metal layers of a metal layer stack, arranged on top of the semiconductor die.

The first charge type may correspond to a p-type doping and the second charge type may correspond to an n-type doping, or vice versa.

According to another aspect of the present disclosure, an ESD protection device is provided that is configured to be electrically connected to an electronic circuit and to protect said electronic circuit from ESD events. The ESD protection device comprises one or more semiconductor devices as described above. The ESD protection device may be a packaged device.

According to yet another aspect of the present disclosure, a device is provided, comprising an electronic circuit integrated on a semiconductor die, and one or more semiconductor devices as described above. The one or more semiconductor devices are integrated on the semiconductor die and are electrically connected to the electronic circuit to protect said electronic circuit from ESD events. The device may be a packaged device.

Next, the present disclosure will be described in more detail with reference to the appended figures, wherein:
Figure 1 is a schematic diagram including an ESD protection device connected to a circuit that is to be protected;
Figures 2A-2D are exemplary cross-sectional views of portions of semiconductor devices according to some embodiments of the present disclosure;
Figures 3A and 3B are schematic top views of a multi-finger structure according to some embodiments of the present disclosure; and
Figures 4A and 4B are top views of a multi-finger structure corresponding to a stacked diode configuration according to some embodiments of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

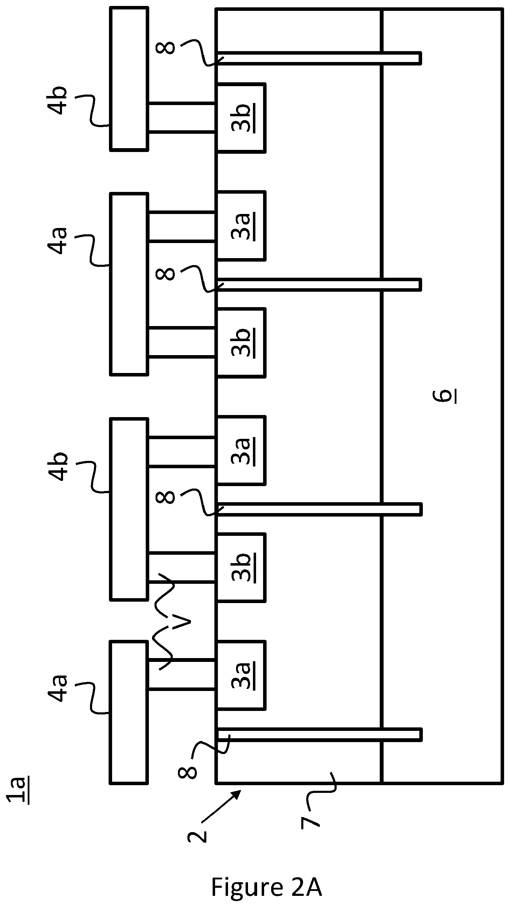

In Figure 2A, a cross-sectional view of a portion of a semiconductor device 1a is shown in accordance with some embodiments of the present disclosure. Semiconductor device 1a comprises a semiconductor die 2 on which a plurality of diode unit cells are integrated. Each unit cell includes a first region 3a of a first charge type (e.g., p-type or n-type) and a second region 3b of a second charge type (e.g., n-type or p-type, respectively). For example, each unit cell forms an individual lateral PN diode.

Semiconductor die 2 comprises a semiconductor substrate 6 and an epitaxial layer 7 grown on top of or above said semiconductor substrate 6. In some embodiments, the plurality of unit cells are integrated on semiconductor die 2 in epitaxial layer 7. However, the plurality of unit cells could instead be arranged in a well region arranged in epitaxial layer 7, which need not be of a same charge type as epitaxial layer 7.

The plurality of unit cells are electrically isolated from one another within semiconductor die 2 by an isolation structure that is arranged in semiconductor die 2. For example, the isolation structure comprises vertical isolation structures and lateral isolation structures that are together configured to isolate each of the plurality of unit cells from one another. In the embodiment shown in Figure 2A, the vertical isolation structures each comprise an electrically isolating trench in which an insulating material 8 may be arranged. The insulating material may be an oxide material, such as silicon dioxide or the like. In some embodiments, the trench itself forms the vertical isolation structure.

The lateral isolation structure in the embodiment shown in Figure 2A comprises a PN junction formed between epitaxial layer 7 and semiconductor substrate 6. To that end, epitaxial layer 7 and semiconductor substrate 6 would be of a different charge type. However, if the unit cells are arranged in a well region in epitaxial layer 7, then epitaxial layer 7 may have a same charge type as semiconductor substrate 6, as long as one of the well region, semiconductor substrate 6 and epitaxial layer 7 has a different charge type from the others. Additionally or alternatively, some or all of the lateral isolation structures may comprise a buried insulating layer (not shown), such as a buried oxide layer.

The trenches corresponding to the vertical isolation structures extend from a top surface of semiconductor die 2, at or near which the unit cells are arranged, through at least part of epitaxial layer 7 and at least down to the lateral isolation structures. The PN junctions corresponding to the lateral isolation structures extend between said trenches. The PN junctions together with the trenches enclose each of the plurality of unit cells so as to electrically isolate them from one another within semiconductor die 2.

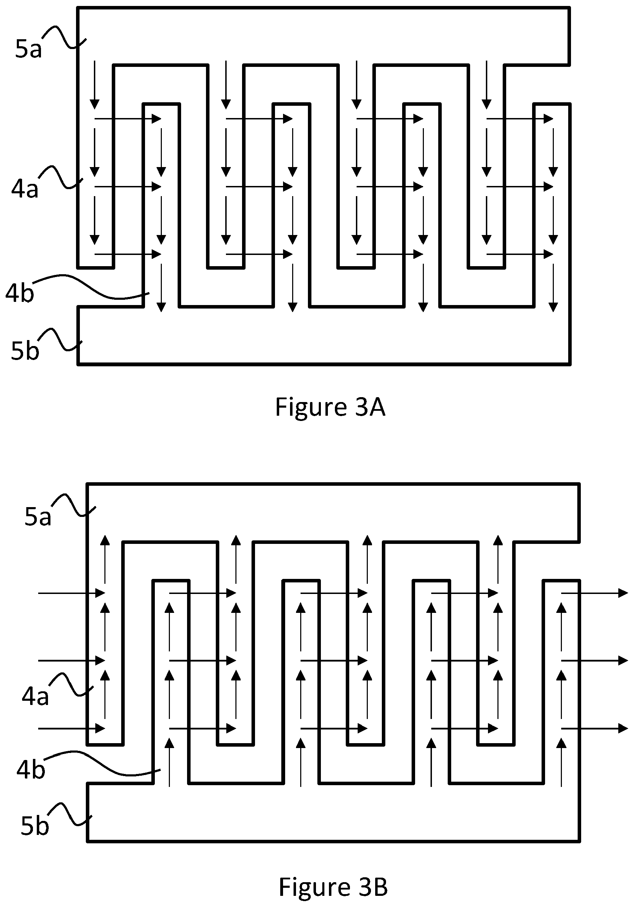

Semiconductor device 1a further comprises a plurality of contacts, comprising first contacts 4a and second contacts 4b. First contacts 4a are electrically connected to a first terminal (not shown) of semiconductor device 1a, and second contacts 4b are electrically connected to a second terminal (not shown) of semiconductor device 1a. Each first contact 4a and each second contact 4b is electrically connected to first region 3a of one unit cell and second region 3b of another unit cell, such as an adjacent unit cell, as shown in Figure 2A. Furthermore, in this embodiment, each unit cell has one of its first and second region 3a, 3b electrically connected to a first contact 4a, and has another of its first and second region 3a, 3b electrically connected to a second contact 4b. As such, a first portion of the plurality of unit cells is arranged in parallel to one another, while a second portion of unit cells is arranged in anti-parallel with unit cells from the first portion. Furthermore, each first contact 4a and each second contact 4b can carry a current in either direction between the first terminal and the second terminal. This will be further detailed below with reference to Figures 3A and 3B.

In the embodiment shown in Figure 2A, first contacts 4a and second contacts 4b are electrically connected to regions from adjacent unit cells, and the plurality of unit cells may be arranged as adjacent rows. For example, first regions 3a and second regions 3b may be elongated in a direction parallel to the viewing direction in Figure 2A. As such, at opposing ends of semiconductor die 2, for example, there may be a first region, corresponding to a first end unit cell (not shown), and a second region, corresponding to a second end unit cell, that are not connected to a first or second contact. To that end, semiconductor device 1a may comprise a first further contact (not shown) electrically connected to the first terminal and to such first or second region, and may comprise a second further contact (not shown) that is electrically connected to the second terminal and to such second or first region. In doing so, the first further contact and the second further contact can only carry a current in a single direction between the first and second terminal, but enable the first end unit cell and second end unit cell to be activated. However, the present invention is not limited thereto.

In an example, first contacts 4a and second contacts 4b are formed in a metal layer or metal layer stack arranged on top of semiconductor die 2, and are electrically connected to first and second regions 3a, 3b using, for example, vias V extending from the top surface of semiconductor die 2 to a corresponding metal layer. The metal layer or metal layer stack may be arranged in a dielectric layer, for example.

The first terminal of semiconductor device 1a may be electrically connected to a first ESD sensitive terminal of a circuit to be protected, such as signal line 31 of Figure 1, and the second terminal of semiconductor device 1a may be electrically connected to a second ESD sensitive terminal of said circuit, such as rail line 32 of Figure 1. One of the first and second ESD sensitive terminal may be a ground terminal.

During an ESD event, the voltage at across the first ESD sensitive terminal and the second ESD sensitive terminal may rise. For example, if an ESD event occurs at the first ESD sensitive terminal, causing a voltage rise at said terminal with respect to the second ESD sensitive terminal, then the ESD event is said to have a first polarity. On the other hand, if an ESD event occurs at the second ESD sensitive terminal, causing a voltage rise at said terminal with respect to the first ESD sensitive terminal, then the ESD event is said to have a second polarity.

Each unit cell may individually form a current path between the first and second ESD sensitive terminal based on a voltage across its PN junction formed between its first and second region. For example, an ESD event having the first polarity causes unit cells having their p-type doped region electrically connected to first contact 4a to activate. Depending on the selected charge type for the first and second charge type, this could be either of first region 3a and second region 3b. For example, during an ESD of the first polarity, the first portion of unit cells are all forward-biased and thus activated, while the second portion of unit cells are reverse-biased and do not conduct a current, or hardly so. Similarly, an ESD event of the second polarity may cause unit cells from the second portion to become forward-biased and thus activated, while unit cells from the first portion are reverse-biased.

By connecting first and second contacts 4a, 4b to both a first region 3a of one unit cell and a second region 3b of another unit cell, each of first and second contacts 4a, 4b can be used to carry a current in either direction between the first ESD sensitive terminal and the second ESD sensitive terminal. Therefore, the amount of metal interconnect of semiconductor device 1a can be substantially reduced, thereby decreasing its capacitive loading on the circuit to which it is connected during normal operation, such as in absence of an ESD event.

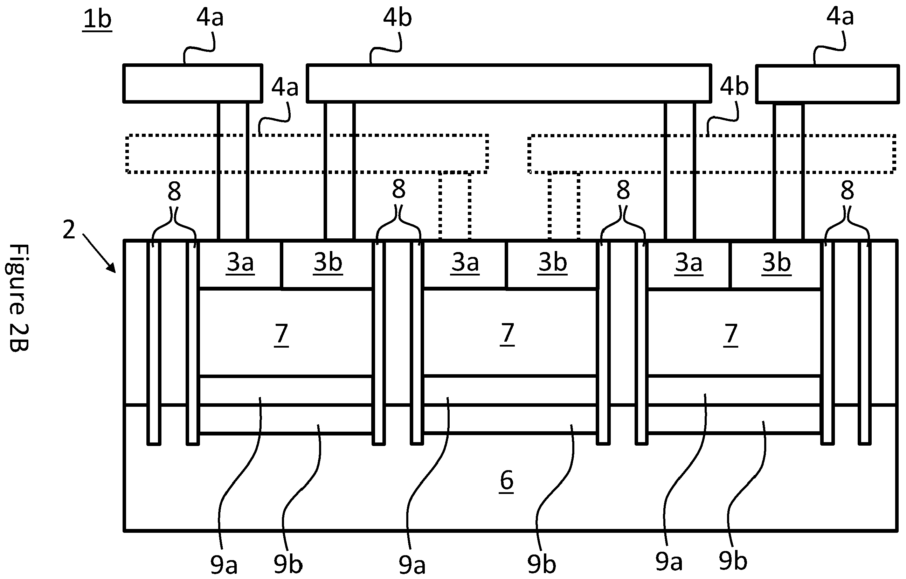

Hereinafter, various exemplary modifications and alternative configurations of semiconductor device 1a, as shown in Figure 2A, will be described with reference to Figures 2B-2D. It is noted that some features shown in each of Figures 2B-2D may be identical or similar to features described above in relation to Figure 2A. A detailed description thereof is therefore omitted. It will be appreciated by a person skilled in the art that at least the modifications described below can be applied to semiconductor device 1a individually with respect to one another, in absence of explicit indications of the contrary.

In Figure 2B, a cross-sectional view of a portion of a semiconductor device 1b is shown in accordance with some embodiments of the present disclosure.

In the embodiment shown in Figure 2B, the PN junctions corresponding to the lateral isolation structures are not formed by junctions between semiconductor substrate 6 and epitaxial layer 7, but by a junction between a first buried region 9a of the first or second charge type and a second buried junction 9b of the second or first charge type, respectively, arranged in semiconductor die 2. In this embodiment, epitaxial layer 7 can have either a same charge type or a different charge type with respect to semiconductor substrate 6. Furthermore, the vertical isolation structures of semiconductor device 1b comprise a plurality (e.g., two) of trenches, optionally having an insulating material 8 arranged therein. For example, as shown in Figure 2B, each unit cell may have two trenches with insulating material 8 associated therewith, providing further isolation from adjacent unit cells.

In semiconductor device 1b, first region 3a and second region 3b of each (or at least one) unit cell are optionally adjacently arranged, such that epitaxial layer 7 does not or hardly forms part of the diode formed by the unit cell. Here, it is noted that the diode formed by each (or at least one) unit cell may also be a PiN diode, for example by including an intrinsic layer in between first region 3a and second region 3b.

In Figure 2A, each first and second contact 4a, 4b is electrically connected to a first and second region 3a, 3b of adjacent unit cells, respectively. However, the present disclosure is not limited thereto. For example, as shown in Figure 2B, each first and second contact 4a, 4b may be electrically connected to a first and second region 3a, 3b of different unit cells that are not directly adjacent to one another. Furthermore, first and second contact 4a, 4b may be arranged in a plurality of layers of a metal layer stack arranged on top of semiconductor die 2.

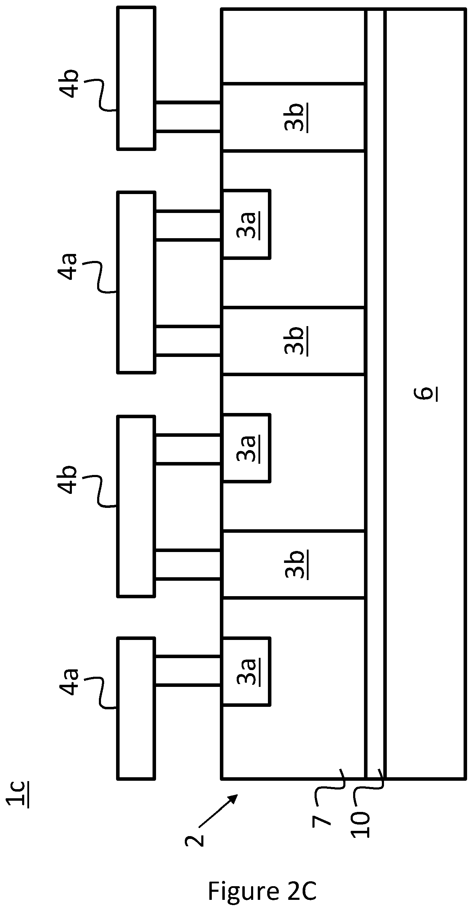

In Figure 2C, a cross-sectional view of a portion of a semiconductor device 1c is shown in accordance with some embodiments of the present disclosure.

In this embodiment, the lateral isolation structures comprise respective portions of a single buried insulating layer 10, though a plurality of individual buried insulating layers for individually isolating each unit cell is also envisaged. Buried insulating layer 10 may be arranged in between semiconductor substrate 6 and epitaxial layer 7. In an example, buried insulating layer 10 may be a buried oxide material, such as silicon dioxide.

Furthermore, when the lateral isolation structures comprise buried insulating layer 10 as shown in Figure 2C, second region 3b (or first region 3a) of each unit cell may extend from a top surface of semiconductor die 2 to buried insulating layer 10. In that case, the vertical isolation structures may be formed by a PN junction between said second regions 3b (or first regions 3a) and epitaxial layer 7 or well region in which said second regions 3b (or first regions 3a) are arranged. To that end, epitaxial layer 7 is of the first charge type opposite the second charge type of second regions 3b (or first regions 3a).

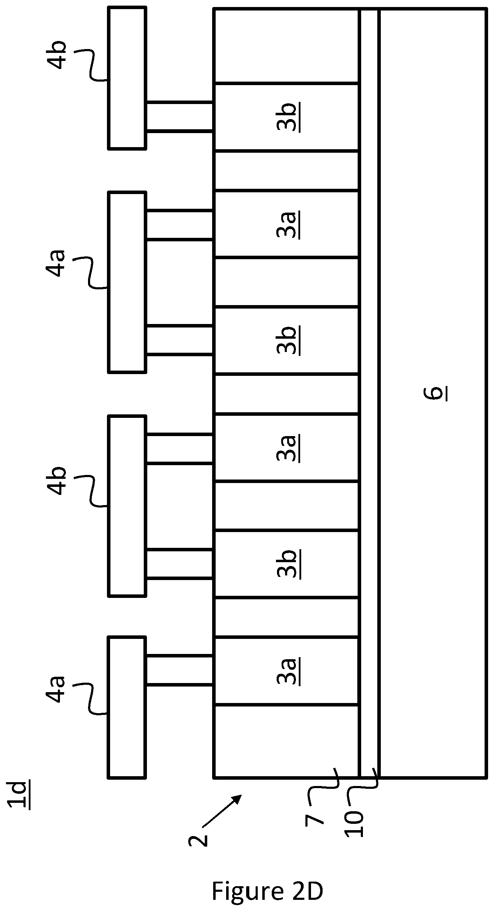

In Figure 2D, a cross-sectional view of a portion of a semiconductor device Id is shown in accordance with some embodiments of the present disclosure.

In this embodiment, each of first and second region 3a, 3b extends from a top surface of semiconductor die 2 to buried insulating layer 10. In this case, the vertical isolation structures are formed by PN junctions between either of the first and second region 3a, 3b and epitaxial layer 7, depending on the selected charge type for epitaxial layer 7.

In another example, first and second region 3a, 3b are adjacently arranged (not shown), and the PN junctions corresponding to the vertical isolation structures are formed by a junction between first region 3a of each unit cell and second region 3b of a unit cell adjacent thereto.

In Figures 3A and 3B, a top view of the plurality of contacts is shown in accordance with some embodiments of the present disclosure. In particular, a current direction is indicated with arrows in Figures 3A and 3B. More in particular, Figure 3A schematically shows a current flow in an example wherein the ESD event has the first polarity, and Figure 3B schematically shows a current flow in an example wherein the ESD event has the second polarity.

As shown in Figures 3A and 3B, first contacts 4a and second contacts 4b may be finger-shaped. Each first contact 4a may be electrically connected to one another via a first interconnecting portion 5a, and each second contact 4b may be electrically connected to one another via a second interconnecting portion 5b. First and second interconnecting portion 5a, 5b may be used as a common terminal or contact by which semiconductor device 1a-1d is configured to be electrically connected to a first ESD sensitive terminal (e.g., signal line 31) and a second ESD sensitive terminal (e.g., rail line 32 or another signal line) of a circuit to be protected.

During an ESD event, each first contact 4a or each second contact 4b forms a 'current transmitting' metal line, while each second contact 4b or each first contact 4a forms a 'current receiving' metal line, respectively. In particular, during such an ESD event, the ESD current will flow from the first ESD sensitive terminal through first contacts 4a, through the semiconductor die (not shown) and subsequently through second contacts 4b towards the second ESD sensitive terminal, as indicated by the arrows in Figure 3A. On the other hand, during an ESD event having the second polarity, the current will flow from the second ESD sensitive terminal through second contacts 4b, through the semiconductor die (not shown) and subsequently through first contacts 4a towards the first ESD sensitive terminal, as shown in Figure 3B. As described above, the first portion of unit cells may therefore be activated during ESD events having the first polarity, and the second portion of unit cells may be activated for ESD events having the second polarity. However, first and second contacts 4a, 4b can carry a current during an ESD event in both directions, irrespective of the polarity of the ESD event.

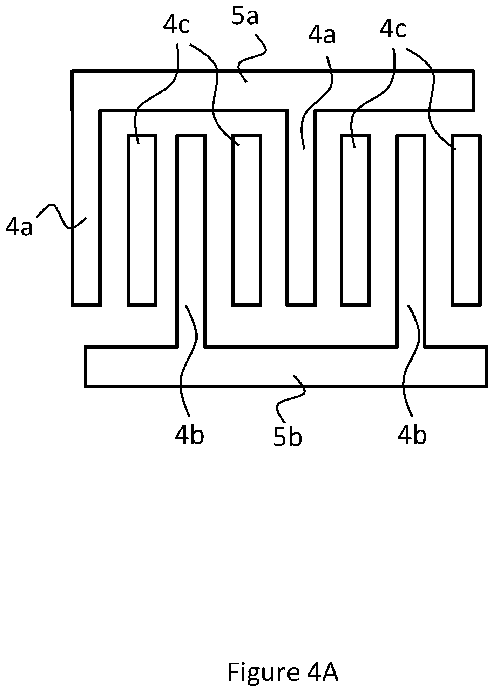

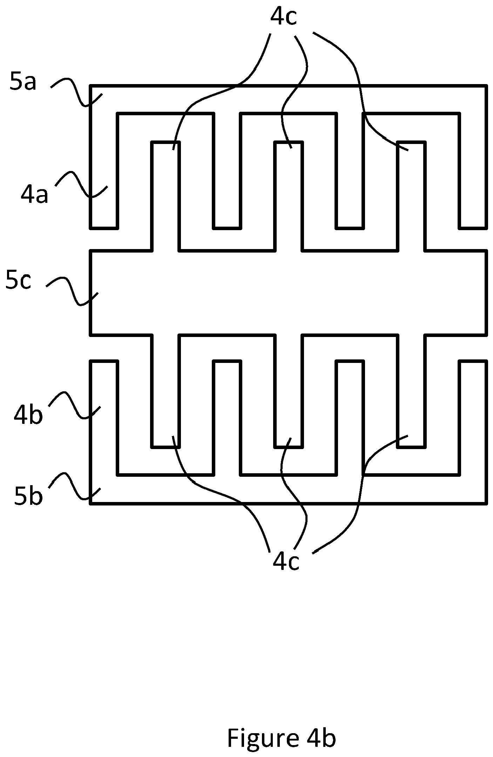

In Figures 4A and 4B, a top view of the plurality of contacts is shown in accordance with some embodiments of the present disclosure. In particular, Figures 4A and 4B are top views of a multi-finger structure corresponding to a stacked diode configuration in which two or more diodes are connected in series. It is noted that a stacked diode configuration may be applied to any of semiconductor device 1a-1d shown in Figures 2A-2D.

Figure 4A differs from Figures 3A and 3B in that the plurality of contacts further comprise intermediate contacts 4c provided in between each adjacent first contact 4a and second contact 4b. Intermediate contacts 4c, similarly to first contacts 4a and second contacts 4b, are electrically connected to the first region of a unit cell and a second region of another (e.g., adjacent) unit cell (not shown). However, unlike first contacts 4a and second contacts 4b, intermediate contacts 4c need not be connected to a terminal of semiconductor device 1a-1d.

Intermediate contacts 4c provide a series connection of unit cells, wherein the remaining first region of a unit cell in said series connection of unit cells is electrically connected to a first contact or second contact, while the remaining second region of another unit cell in said series connection of unit cells is electrically connected to a second contact or first contact, respectively. In doing so, a plurality of groups of series connected unit cells are formed in between the first and second terminal of semiconductor device 1a-1d, corresponding to a stacked diode implementation.

The concept shown in Figure 4A may be extended further by providing a plurality of said intermediate contacts 4c in between each pair of first contact 4a and second contact 4b, thereby connecting even more unit cells in series in each group of unit cells. For example, instead of only two unit cells being connected in series via one intermediate contact 4c, two or more intermediate contacts 4c may be provided between first contact 4a and second contact 4b to connect three or more unit cells in series.

In this embodiment, similarly to Figures 3A and 3B, first contacts 4a and second contacts 4b can carry a current in both directions between the first terminal and the second terminal. However, intermediate contacts 4c only carry a current in a single direction, depending on whether the corresponding unit cells are forward-biased or not.

Figure 4B is another implementation of a stacked diode configuration. In this embodiment, a first portion of intermediate contacts 4c is interleaved with first contacts 4a, and a second portion of intermediate contacts 4c is interleaved with second contacts 4b. In this case, intermediate contacts 4c can also carry a current in both directions between the first and second terminal, the direction depending on the polarity of the ESD event. As such, an implementation according to Figure 4B allows for a more area efficient implementation.

Intermediate contacts 4b may be electrically connected to one another via an intermediate interconnecting portion 5c, though the present invention is not limited thereto. For example, each intermediate contact 4c in between first contacts 4a may instead be associated with and electrically connected to one or more intermediate contacts 4c in between second contacts 4b.

Semiconductor devices 1a-1d may be arranged in a semiconductor device package (not shown), as will be appreciated by a person skilled in the art. For example, one or more semiconductor devices 1a-1d (or various combinations thereof) may be arranged in a single package forming an ESD protection device (e.g., ESD protection device 20 of Figure 1). Such a package may have a first device terminal, for example formed by a first lead, and a second device terminal formed by a second lead, which device terminals are electrically connected to first contacts 4a and second contacts 4b, respectively, either directly or indirectly through first and second interconnecting portions 5a, 5b. The first and second device terminals of the package may be formed by leads by which the package can be mounted to an external surface, such as a printed circuit board, PCB, and/or electrically connected to an external circuit to be protected. In another example, the circuit to be protected is also included in the package, and may also be integrated on semiconductor die 2.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A semiconductor device (1a; 1b; 1c; 1d) having a first terminal and a second terminal, the semiconductor device (1a; 1b; 1c; 1d) comprising:
a semiconductor die (2);
a plurality of diode unit cells integrated on the semiconductor die (2) and being electrically connected between the first and second terminal, each unit cell comprising a first region (3a) of a first charge type in the semiconductor die (2) and a second region (3b) of a second charge type in the semiconductor die (2);
an isolation structure arranged in the semiconductor die (2), the isolation structure being configured to electrically isolate the plurality of unit cells from one another in the semiconductor die (2); and
a plurality of contacts comprising first contacts (4a) that are electrically connected to the first terminal and second contacts (4b) that are electrically connected to the second terminal,
wherein each contact among the first and second contacts (4a, 4b) is electrically connected to the first region (3a) of a respective unit cell among the plurality of unit cells and to the second region (3b) of another unit cell among the plurality of unit cells.

2. The semiconductor device (1a; 1b; 1c; 1d) according to claim 1, wherein the plurality of unit cells are arranged in a plurality of groups, each group having two or more unit cells that are connected in series via one or more intermediate contacts (4c), each intermediate contact (4c) being electrically connected to the first region (3a) of a respective unit cell among unit cells in said group and to the second region (3b) of another unit cell among unit cells in said group.

3. The semiconductor device (1a; 1b; 1c; 1d) according to claim 2, wherein a first portion of intermediate contacts (4c) is arranged in an interleaved manner with first contacts (4a), and wherein a second portion of intermediate contacts (4c) are arranged in an interleaved manner with second contacts (4b), and wherein intermediate contacts (4c) among the first portion of intermediate contacts (4c) are each electrically connected to at least one intermediate contact (4c) among the second portion of intermediate contacts (4c); or
wherein the first contacts (4a) and the second contacts (4b) are alternatingly arranged, wherein the intermediate contacts (4c) are arranged in between said first contacts (4a) and second contacts (4b).

4. The semiconductor device (1a; 1b; 1c; 1d) according to any of the previous claims, wherein unit cells that are electrically connected to a same first contact (4a), a same second contact (4b) and/or, if applicable, a same intermediate contact are adjacently arranged; and/or
wherein a first portion of the plurality of unit cells or, in so far as depending on claim 2, the plurality of groups is arranged in parallel to one another between the first and second terminal, and wherein a second portion of the plurality of unit cells or, in so far as depending on claim 2, the plurality of groups is arranged in anti-parallel to the first portion between the first and second terminal; and/or
wherein the first contacts (4a) are electrically connected to one another via a first interconnecting portion (5a), the first interconnecting portion (5a) forming or being electrically connected to the first terminal, and/or wherein the second contacts (4b) are electrically connected to one another via a second interconnecting portion (5b), the second interconnecting portion (5b) forming or being electrically connected to the second terminal; and/or
wherein the first contacts (4a), the second contacts (4b) and/or, if applicable, the intermediate contacts (4c) are finger-shaped.

5. The semiconductor device (1a; 1b; 1c; 1d) according to any of the previous claims, wherein the semiconductor die comprises a semiconductor substrate (6) and an epitaxial layer (7), wherein the plurality of unit cells are formed in the epitaxial layer (7).

6. The semiconductor device (1a; 1b; 1c; 1d) according to any of the previous claims, wherein the isolation structure comprises a plurality of vertical isolation structures and a plurality of lateral isolation structures, wherein the vertical isolation structures are each arranged in between adjacent unit cells among the plurality of unit cells, and wherein the plurality of lateral isolation structures are each arranged below a respective unit cell among the plurality of unit cells with respect to a top surface of the semiconductor die (2), wherein the vertical isolation structures extend from said top surface at least to the lateral isolation structures, wherein the vertical isolation structures each preferably extend from the top surface in a first direction that is substantially perpendicular to said top surface, and wherein the lateral isolation structures each preferably extend in a second direction that is substantially parallel to said top surface.

7. The semiconductor device (1a; 1b; 1c; 1d) according to claim 6, wherein the lateral isolation structures are formed by respective buried insulating layers, such as buried oxide layers, wherein the buried insulating layers together preferably form respective portions of a contiguous buried insulating layer (10).

8. The semiconductor device (1a; 1b) according to claim 6, wherein the plurality of lateral isolation structures are formed by respective PN junctions extending between the vertical isolation structures arranged adjacent to a corresponding unit cell.

9. The semiconductor device (1a) according to claim 8, in so far as depending on claim 5, wherein the epitaxial layer (7) is of a different charge type with respect to the semiconductor substrate (6), and wherein the PN junctions are formed by junctions between the epitaxial layer (7) and the semiconductor substrate (6); or
wherein a well region in the epitaxial layer (7) in which the plurality of unit cells are arranged is of a different charge type with respect to a remainder of the epitaxial layer (7) and/or the semiconductor substrate (6), and wherein the PN junctions are formed by respective junctions between the epitaxial layer (7) and the semiconductor substrate (6), and/or by respective junctions between the well region and the epitaxial layer (7).

10. The semiconductor device (1b) according to claim 8, in so far as depending on claim 5, wherein the PN junctions are each formed by a respective first buried region (9a) of the first or second charge type in the semiconductor die (2) and a respective second buried region (9b) of the second or first charge type, respectively, in the semiconductor die (2), wherein each of the second buried regions (9b) are spaced apart from the epitaxial layer (7) by a corresponding first buried region (9a).

11. The semiconductor device (1a; 1b) according to any of the claims 7-11, wherein the vertical isolation structures each comprise a trench, wherein the trench preferably has an insulating material (8) arranged therein, such as an oxide material.

12. The semiconductor device (1c; 1d) according to claim 7,
wherein, in so far as depending on claim 5, one of the first and second region (3a, 3b) of each unit cell among the plurality of unit cells extends from a top surface of the semiconductor die (2) to the buried insulating layer (10), wherein the epitaxial layer (7) or a well region in the epitaxial layer (7) in which the plurality of unit cells are arranged is of the second charge type, and wherein the vertical isolation structures are each formed by a respective PN junction between said one of the first and second region (3a, 3b) of a respective unit cell and the epitaxial layer (7) or the well region; and/or
wherein the first region (3a) and the second region (3b) of each unit cell among the plurality of unit cells extends from a top surface of the semiconductor die (2) to the buried insulating layer (10), wherein the vertical isolation structures are formed by respective PN junctions between one of the first or second region of a respective unit cell and the epitaxial layer (7) or, if applicable, a well region in the epitaxial layer (7) in which the plurality of unit cells are arranged, or between the first region (3a) of a respective unit cell and the second region (3b) of a unit cell arranged directly adjacent to said first region (3a).

13. The semiconductor device (1a; 1b; 1c; 1d) according to any of the previous claims, wherein the plurality of contacts and, if applicable, the first and second interconnecting portions (5a, 5b) are arranged in a metal layer, or in one or more metal layers of a metal layer stack, arranged on top of the semiconductor die (2); and/or
wherein the first charge type corresponds to a p-type doping and wherein the second charge type corresponds to an n-type doping, or vice versa.

14. An electrostatic discharge, ESD, protection device (20) configured to be electrically connected to an electronic circuit (30) and to protect said electronic circuit (30) from ESD events, wherein the ESD protection device (20) comprises one or more semiconductor devices (1a; 1b; 1c; 1d) as defined in any of the previous claims, and wherein the ESD protection device (20) is preferably a packaged device.

15. A device comprising an electronic circuit integrated on a semiconductor die, and one or more semiconductor devices (1a; 1b; 1c; 1d) as defined in any of the claims 1-13, wherein the one or more semiconductor devices (1a; 1b; 1c; 1d) are integrated on said semiconductor die and are electrically connected to the electronic circuit to protect said electronic circuit from ESD events, wherein the device is preferably a packaged device.
